# FASCICULE DE BREVET EUROPEEN

(11) **EP 3 602 197 B1**
(45) Date de publication et mention de la délivrance du brevet: **09.11.2022**
(21) Numéro de dépôt: 18712472.2
(22) Date de dépôt: 16.03.2018
(51) Int. Cl.: G03F 7/00, G04B 13/02

(54) **PROCÉDÉ DE FABRICATION D'UN COMPOSANT HORLOGER EN MÉTAL-CÉRAMIQUE**
VERFAHREN ZUR HERSTELLUNG EINER METALL-KERAMIK-UHRKOMPONENTE
PROCESS FOR MANUFACTURING A METAL-CERAMIC TIMEPIECE COMPONENT

(30) Priorité: 24.03.2017 CH 3912017
(43) Date de publication de la demande: 05.02.2020
(73) Titulaire: Richemont International SA, 1752 Villars-sur-Glâne (CH)
(72) Inventeur: CHABART, Mickaël, 2300 La Chaux-de-Fonds (CH); OSOWIECKI, Jacques, 2015 Areuse (CH)
(74) Mandataire: P&TS SA (AG, Ltd.)
(86) Numéro de dépôt international: PCT/IB2018/051775
(87) Numéro de publication internationale: WO 2018/172895

(56) Documents cités:
- EP-A1- 1 835 339
- EP-A1- 1 927 681
- EP-A1- 2 088 482
- EP-A1- 2 767 869
- CH-A2- 699 416
- CH-A2- 703 781
- US-A1- 2011 045 249

## Description

### Domaine technique

La présente invention concerne un procédé pour la fabrication d'un composant horloger en métal-céramique, le procédé permettant fabriquer économiquement un composant complexe de haute précision et ayant des propriétés mécaniques et tribologiques favorables.

### Etat de la technique

Dans le but de réaliser des pièces ou composants mécaniques d'une très grande précision et ayant des épaisseurs de quelques centaines de microns, voire jusqu'à plusieurs millimètres, un procédé de fabrication par irradiation d'une couche photosensible aux rayons ultraviolets suivie d'une étape d'électroformage est connu et est décrit par exemple dans le brevet EP0851295. Ce procédé est dérivé de la technique LIGA (Lithographie Galvanoformung Abformung) qui consiste à déposer sur un substrat une couche de 1 à 2000 µm d'une résine photosensible, à effectuer à travers un masque une irradiation au moyen d'un synchrotron ou par une exposition de rayons ultraviolets, à développer les portions irradiées (ou non irradiées) de la résine de manière à former un moule en résine, et à électroformer un métal dans ce moule afin d'obtenir la micro pièce métallique.

Le document CH699416 A2 décrit également un procédé de fabrication d'une structure métallique multi-niveaux par une technique LIGA. En particulier, un film métallique mince servant d'amorce est formé par un dépôt métallique exempt d'activation électrique.

Actuellement, les matériaux qui sont déposés par croissance galvanique (électroformage) comprennent le plus souvent le cuivre ou l'or, le nickel ou le nickel phosphore. Pour des applications de types horlogères, ces matériaux ont des propriétés mécaniques qui ne sont soit pas satisfaisantes pour la production de composants sollicités mécaniquement (cuivre et or), ou soit ont de mauvaise propriété tribologiques (nickel et nickel phosphore). De plus ces matériaux sont difficiles à épilamer.

De manière à améliorer les propriétés tribologiques de pièces fabriquées en nickel par un procédé LIGA, des particules de PTFE peuvent être codéposées avec le nickel lors du procédé d'électroformage. Par ailleurs, le document US 2011 045249 A1 décrit un procédé de fabrication d'un composant horloger composé de 3 couches, le procédé comprenant une étape de lithographie suivie de trois dépositions de métal successives. Une gravure sélective de la couche intermédiaire permet de former une cavité facilitant la lubrification. Les couches supérieures et inférieures comprennent un métal ou un alliage métallique et des particules céramiques - Al₂O₃ ou SiC - codéposées avec le métal ou l'alliage métallique par un procédé de métallisation électrochimique, la présence des particules de céramique augmentant d'une part la dureté du matériau et d'autre part la force de cohésion aux interfaces desdites couches.

### Bref résumé de l'invention

Selon l'invention, un procédé pour la fabrication d'un composant horloger, comprend les étapes de:
se munir d'un substrat dont au moins une des faces est destinée à recevoir une résine structurable;
appliquer sur ladite au moins une face une couche de la résine structurable;
structurer la résine de manière à former un moule comprenant des ouvertures laissant apparaitre une surface active, la surface active comportant au moins un premier niveau;
former un dépôt métallique dans les ouvertures du moule en résine;
libérer le dépôt métallique du moule et du substrat de sorte à obtenir le composant;
une première couche d'amorce étant formée sur, ou réalisée par, au moins une partie du premier niveau de ladite surface active avant de former le dépôt métallique, le dépôt métallique comprenant un métal ou un alliage métallique et des particules céramiques codéposées avec le métal ou l'alliage métallique par un procédé de métallisation chimique.

Dans le présent texte, le terme « métallisation chimique » fait exclusivement référence aux métallisations chimiques exemptes d'activation électrique, et le terme « métallisation électrochimique » fait référence aux procédés de métallisation activés par un champ électrique, comme la galvanoplastie ou l'électrodéposition.

Dans le présent texte, tous les pourcentages sont massiques lorsque pas spécifiés autrement.

Le dépôt métallique composite peut être basé sur un dépôt de nickel phosphore déposé à partir d'un bain de nickel chimique ou galvanique.

Les particules céramiques peuvent comprendre des particules de carbure, d'oxyde, de nitrure, de fluorure, ou une combinaison de ces particules. Les particules céramiques peuvent comprendre du fluorure de cérium (CeF3), des particules de carbure de silicium (SiC), des particules d'alumine (Al2O3) ou une combinaison de ces particules. De manière préférée, les particules de céramique peuvent comprendre des particules de nitrure de bore hexagonal (h-BN).

### Brève description des figures

Des exemples de mise en oeuvre de l'invention sont indiqués dans la description illustrée par les figures annexées dans lesquelles:
la figure 1 montre un exemple d'un substrat comportant une face comprenant une première couche d'amorce, destinée à recevoir une résine structurable, selon un mode de réalisation;
les figures 2a et 2b illustrent de manière schématique un procédé pour la fabrication d'un composant horloger métallique, selon un mode de réalisation;
la figure 3 montre un dépôt métallique formé dans des ouverture d'un moule de la résine sur le substrat, selon un mode de réalisation;
la figure 4 représente le dépôt métallique libéré de la résine et du substrat;
La figure 5 illustre la formation de la première couche d'amorce, selon un mode de réalisation;
la figure 6 illustre la formation de la première couche d'amorce, selon un autre mode de réalisation;
la figure 7 illustre la formation de la première couche d'amorce, encore selon un autre mode de réalisation;
la figure 8 illustre une étape de dépôt de la résine, selon un mode de réalisation;
la figure 9 montre la formation de la première couche d'amorce selon la figure 6 après exposition et développement de la résine, selon un mode de réalisation;
la figure 10 illustre la formation de la deuxième couche d'amorce sur un premier niveau de la résine, selon un mode de réalisation;
la figure 11 illustre la formation d'une deuxième couche d'amorce sur un premier niveau de la résine, selon un autre mode de réalisation;
la figure 12 illustre la formation d'une deuxième couche d'amorce sur un premier niveau de la résine, encore selon un autre mode de réalisation;
la figure 13 illustre la formation d'un deuxième niveau de la résine structurable, selon un mode de réalisation;
la figure 14 illustre la formation d'un deuxième niveau de la résine structurable, selon un autre mode de réalisation;
la figure 15 illustre la formation d'une première et d'une deuxième couches d'amorce, encore selon un autre mode de réalisation;
la figure 16, représente le substrat comportant une structure et le dépôt métallique remplissant cette structure, selon un mode de réalisation;
la figure 17 illustre la formation d'une première couche structurée sur le substrat, selon un mode de réalisation;
la figure 18 montre un insert inséré dans le dépôt métallique, selon un mode de réalisation;
la figure 19 représente un procédé d'usinage sur une face du dépôt métallique, selon un mode de réalisation; et
la figure 20 représente un procédé d'usinage sur une face du dépôt métallique, selon un autre mode de réalisation.

### Exemple(s) de mode de réalisation de l'invention

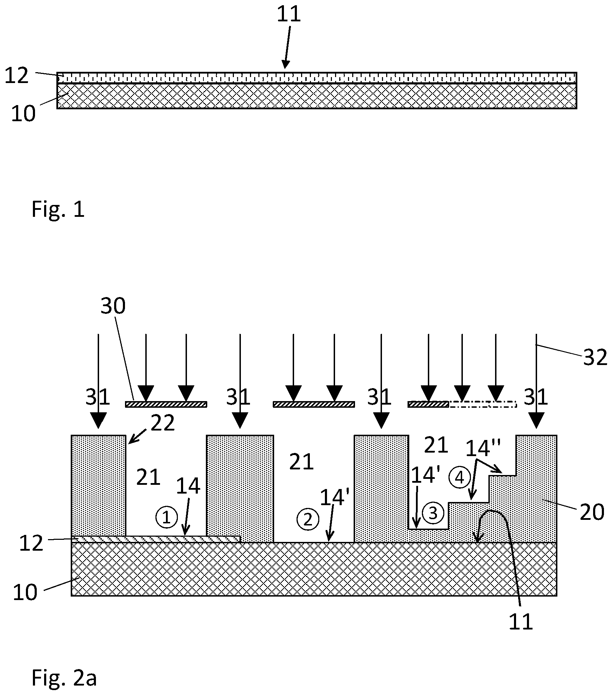

La figure 1 montre un exemple d'un substrat 10 comportant une face 11 destinée à recevoir une résine structurable 20.

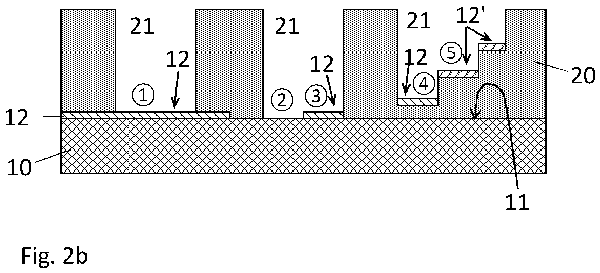

Les figures 2a et 2b illustrent de manière schématique un procédé pour la fabrication d'un composant horloger métallique, selon un mode de réalisation. Le procédé est basé sur une déposition du métal de manière sélective à l'aide d'une couche de résine structurée 20.

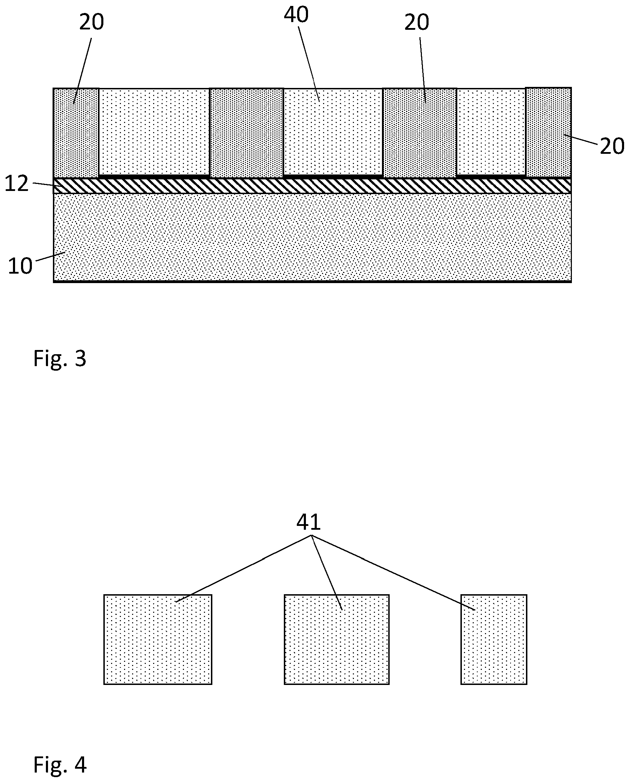

Dans les grandes lignes, le procédé comprend les étapes de fournir un substrat 10 comportant au moins une face 11 sur laquelle est appliquée, directement ou sur une ou plusieurs couches intermédiaires, une couche de résine structurable 20. La couche de résine 20 est ensuite structurée de manière à former dans celle-ci des ouvertures 21 qui laissent apparaitre une surface active 14, c'est-à-dire une surface destinée à recevoir le dépôt métallique. Dans l'exemple de la figure 2a, la surface active 14 peut correspondre aux portions exposées de la face 11 qui ne sont pas recouvertes par la résine 20, comportant une première couche d'amorce (variante ①), ou sur le substrat lui-même (variante ②). La surface active 14 peut également correspondre à un premier niveau 14' situé sur une couche de résine, comme illustré en ③, définissant de manière analogue le fond 21 du moule en résine 20. La variante ④ montre la couche de résine 20 structurée présentant plusieurs niveaux (deuxièmes niveaux 14" de la surface active 14). La forme du contour des ouvertures 22 correspond substantiellement à la forme du composant 41 à produire. Un dépôt métallique 40 est alors formé dans les ouvertures 21 de la couche de résine 20 structurée (qui forme alors un moule) par déposition du métal (voir la figure 3). En répartissant le moule sur plusieurs faces du substrat, comme par exemple les deux faces principales d'un substrat, pouvant par exemple avoir substantiellement la forme d'un disque, il est possible d'accroître de manière avantageuse le nombre de composants réalisés au cours d'une même étape d'un dépôt métallique. Après la déposition, le dépôt métallique 40 formé est libéré de la résine 20 et du substrat 10 afin d'obtenir le composant 41 (voir la figure 4).

Dans l'exemple des figures 1 et 3 et de la variante ① des figures 2a et 2b, le substrat 10 comporte une première couche d'amorce 12 sur la face 11, le dépôt métallique 40 étant formé sur les portions n'étant pas recouvertes par la résine 20 (surface active 14). La première couche d'amorce 12 peut être une couche catalytique ou susceptible d'être rendue catalytique. La première couche d'amorce 12 peut ne recouvrir que partiellement la face 11 et/ou la surface active 14. La première couche d'amorce 12 peut avoir une épaisseur monoatomique ou une certaine épaisseur, ou encore être continue ou discontinue.

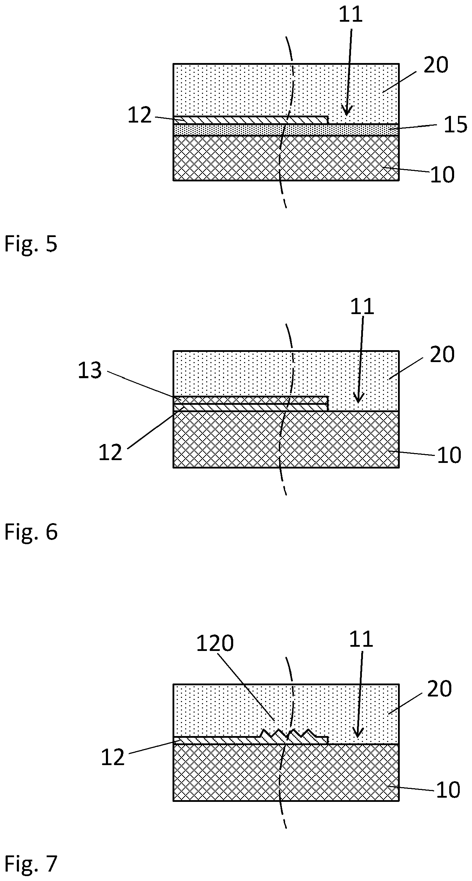

La figure 5 illustre la formation de la première couche d'amorce 12 avant déposition de la résine 20 structurable, dans laquelle la couche d'amorce 12 peut recouvrir la face 11 du substrat 10 de manière totale ou partielle. La première couche d'amorce 12 peut être formée sur une couche d'accroche et/ou sacrificielle 15 déposée sur le substrat 10 avant déposition de la résine structurable 20. Par accroche, on entend que la couche 15 facilite l'adhésion de la première couche d'amorce 12, et par sacrificielle, on entend que la couche 15 facilite la séparation du dépôt métallique par rapport au substrat.

La figure 6 illustre la formation d'une première couche d'amorce 12 sur la face 11 du substrat 10, ainsi que d'une couche isolante 13, c'est-à-dire une couche non catalytique, formée sur la première couche d'amorce 12, avant déposition de la résine 20 structurable. La formation de la couche 13 peut être obtenue par déposition ou par réaction du matériau de la couche 12, comme par exemple une oxydation métallique.

La figure 7 illustre la première couche d'amorce 12 pouvant comporter au moins une portion de surface structurée 120 et qui est formée sur la face 11. Dans les exemples des figures 5 à 7, la première couche d'amorce 12 peut recouvrir au moins une portion de la face 11. Par au moins une portion de surface, on entend une partie ou l'intégralité de la surface.

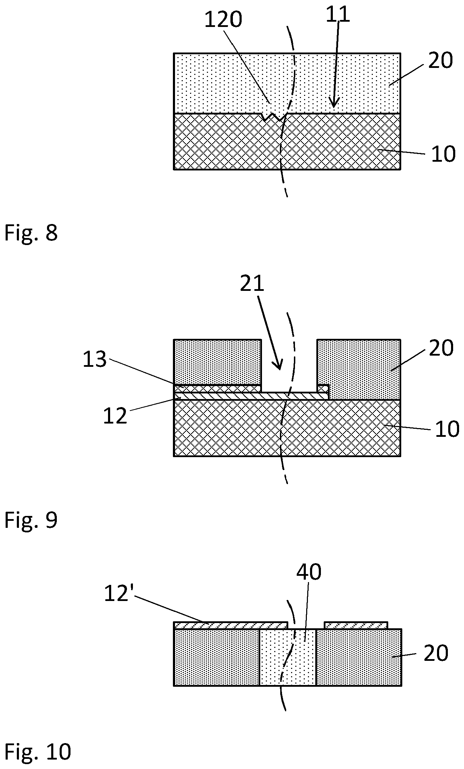

La figure 8 illustre une variante dans laquelle la résine 20 structurable est déposée directement sur la face 11 du substrat 10 qui peut comporter une structuration 120 au moins sur une portion de la face 11. Le substrat 10 peut être réalisé dans un matériau catalytique ou susceptible d'être rendu catalytique. Dans ce cas, la première couche d'amorce 12 est la face 11 du substrat 10, et constitue le premier niveau 14' de la surface active 14 après obtention du moule.

La figure 9 montre la variante de la figure 6 après exposition et développement de la résine 20 structurable et retrait de la couche isolante 13 dans le fond des ouvertures 21 ainsi réalisées.

Dans un mode de réalisation, les étapes d'appliquer la couche de résine structurable 20 et de structurer la résine 20 sont répétées afin d'obtenir un moule à plusieurs niveaux. Le dépôt métallique 40 est formé dans les ouvertures 21 de la couche de résine 20, une fois que le moule à plusieurs niveaux a été formé.

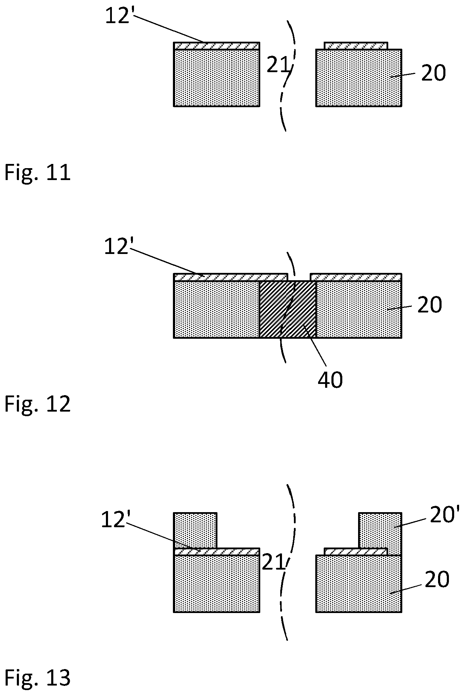

Un moule à plusieurs niveaux est de manière préférentielle réalisé avec des niveaux définis par des géométries dont la superficie va de manière croissante en partant du premier niveau côté substrat, et dont la géométrie comprend celle de l'ouverture réalisée dans le niveau précédent, comme par exemple illustré dans les figures 13 à 15.

Afin de permettre une croissance homogène du dépôt métallique multiniveaux, lorsqu'il est réalisé en une seule étape, il est préférable de former une deuxième couche d'amorce 12' conductrice mais non catalytique, sur au moins une portion des deuxièmes niveaux 14" de la surface active 14.

Dans une variante, le dépôt métallique 40 est formé à chacune des étapes d'appliquer la couche de résine structurable 20 et de structurer la résine 20. Autrement dit, les étapes d'appliquer la couche de résine structurable 20, de structurer la résine 20 et de former le dépôt métallique 40 sont répétées afin d'obtenir un moule, rempli de métal, à plusieurs niveaux. Dans ce cas, une deuxième couche d'amorce 12', qui peut être formée sur au moins une portion des deuxièmes niveaux 14" de la surface active 14 (voir la variante ④ dans les figures 2a et 2b), peut être conductrice et/ou catalytique. Sans sortir du cadre de l'invention, il est possible de réaliser un composant multimatériaux, deux niveaux pouvant être réalisés dans des matériaux différents. Un même niveau du composant peut aussi être réalisé avec plus d'un matériau, ceci permettant d'adapter les propriétés de chaque niveau du composant aux contraintes auxquelles il est soumis lors de sa mise en oeuvre dans un mécanisme.

La figure 10 illustre la formation d'une deuxième couche d'amorce 12' sur premier niveau d'une couche de résine 20 structurable, avant la structuration. La deuxième couche d'amorce 12' peut être formée sur la totalité ou une portion de la face du premier niveau de la couche de résine 20 structurable. La deuxième couche d'amorce est dans ce cas de préférence conductrice mais non catalytique.

La figure 11 illustre la formation de la deuxième couche d'amorce 12' sur un premier niveau de la couche de résine 20 structurable après structuration. La couche d'amorce 12' peut être formée sur la totalité ou une portion de la face du premier niveau de la couche de résine 20 structurable. La deuxième couche d'amorce est dans ce cas de préférence conductrice mais non catalytique.

La figure 12 illustre la formation de la deuxième couche d'amorce 12' sur un premier niveau de la couche de résine 20 structurable après structuration et après la déposition d'un dépôt métallique 40 dans les ouvertures 21. La deuxième couche d'amorce 12' peut être formée sur la totalité ou une portion de la face du premier niveau de la couche de résine 20 structurable. La deuxième couche d'amorce 12' peut donc recouvrir que la résine 20, le dépôt métallique 40 ou les deux. La couche d'amorce peut dans ce cas être catalytique et/ou conductrice.

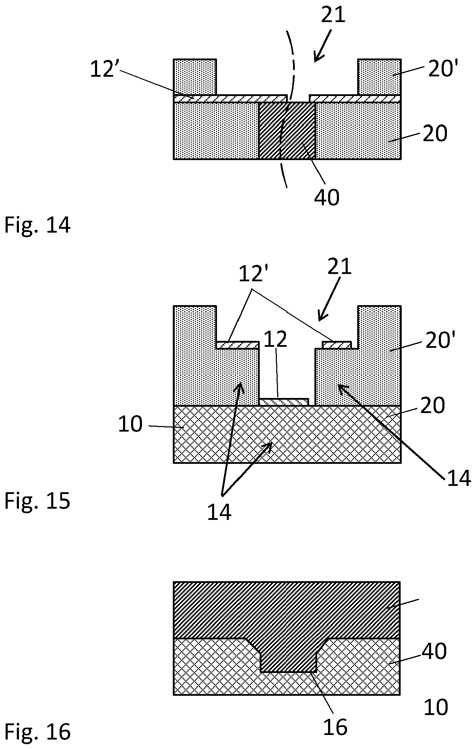

La figure 13 illustre la formation d'un deuxième niveau 20' de la couche de résine structurable 20, après structuration du niveau précédent. Une deuxième couche d'amorce 12' est comprise entre un premier niveau 20 de résine et le deuxième niveau 20' de résine. La formation du deuxième niveau de résine 20' peut être réalisée avant (par exemple figure 15) ou après (par exemple figures 10 à 14) la formation d'une deuxième couche d'amorce 12' sur le premier niveau de résine 20 structurable. Alternativement, le deuxième niveau de résine 20' peut être formé avant la structuration du premier niveau de résine 20. La deuxième couche d'amorce est dans ce cas de préférence conductrice mais non catalytique.

La figure 14 illustre la formation d'un deuxième niveau de résine 20', après la structuration et la formation du dépôt métallique 40. Une deuxième couche d'amorce 12' est formée sur le premier niveau de résine 20, avant ou après formation du deuxième niveau de résine 20'. La deuxième couche d'amorce 12' peut dans ce cas être catalytique et/ou conductrice.

La figure 15 illustre la formation d'une première couche d'amorce 12 sur la surface active 14 dégagée par les ouvertures 21 formées dans le premier niveau et d'une deuxième couche d'amorce 12' sur les surfaces parallèles aux couches du moule et dégagées par les niveaux suivants du moule de résine. Dans l'exemple de la figure 15, la surface active 14 comprend une portion exposée de la face 11 du substrat 10 et une portion exposée du premier niveau de résine 20 et peut être constituée d'une première couche d'amorce 12 ainsi que d'une deuxième couche d'amorce 12'.

Dans l'exemple de la figure 16, le procédé met en oeuvre l'utilisation d'un substrat 10 comportant une structure 16 dans laquelle le dépôt métallique 40 peut être déposé, par exemple en formant une surface active au fond d'une ouverture d'une couche de résine 20. Sur la figure 16, seuls le dépôt métallique 40 et le substrat 10 sont visibles, la surface active 14 étant dans ce cas de préférence obtenue par la formation d'une première couche d'amorce 12, non illustrée mais comme celle décrite dans les exemples des figures 5 à 7, réalisée dans le fond de la structure 16 du substrat. Toutefois, selon la profondeur et la topologie de la structure 16, la surface active peut être obtenue par la formation d'une couche catalytique ou susceptible d'être rendue catalytique ou par l'utilisation d'un substrat catalytique ou susceptible d'être rendu catalytique.

La structuration préalable du substrat offre l'avantage de pouvoir réaliser un dépôt métallique 40 multiniveaux dont au moins un niveau est obtenu par la structuration du substrat. Le moule en résine structurable peut alors ne comprendre qu'un seul niveau, le ou les autres niveaux supplémentaires étant conformes à la structuration 16 du substrat. Il permet aussi de réaliser des géométries à flancs non verticaux, tels que des anglages par exemple. La structure peut également consister en une décoration qui sera réalisée sur le substrat sous une forme d'empreinte négative, pour en obtenir la forme positive sur le composant obtenu. Dans ce cas, l'empreinte négative peut être réalisée en retrait de la surface principale du substrat qui reçoit la couche de résine photostructurable, de manière saillante, ou une combinaison des deux.

Une variante permet encore de combiner les géométries des deux techniques, comme par exemple un composant horloger comportant une goutte et un trou en son centre. Le contour extérieur de la goutte n'a pas besoin d'être aussi précis que le reste du composant et peut résulter du procédé de structuration du substrat. Le trou traversant du composant peut être réalisé lors d'une seule étape de structuration et de déposition métallique, dans les deux niveaux (la structure 16 et la couche de résine 20) du moule hybride.

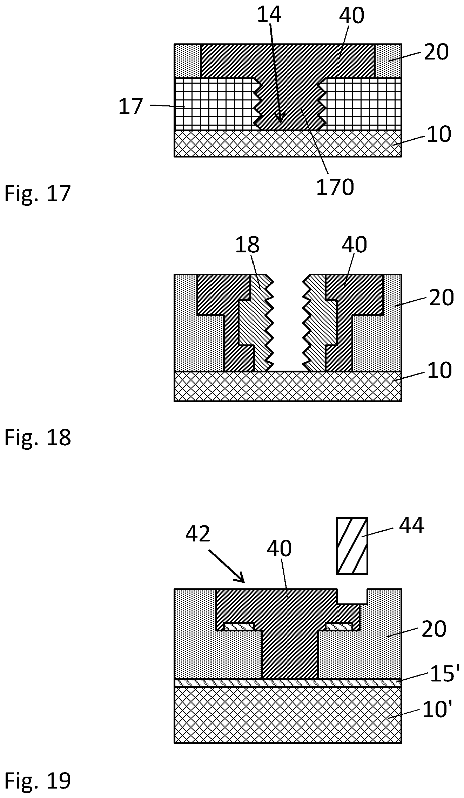

La figure 17 illustre une variante du procédé comprenant une étape de former une couche structurée 17 sur la face 11 du substrat 10. La couche structurée 17 comporte des ouvertures 170 laissant apparaître une surface active 14, correspondant à celle du substrat 10 ou à celle d'une couche recouvrant la face 11 du substrat 10, telle qu'une première couche d'amorce 12 ou toute variante proposée dans les exemples des figures 1 à 8. Les flans des ouvertures 170 de la couche structurée 17 peuvent comprendre un ou des motifs 171 de manière à ce que le dépôt métallique 40 déposé dans la ou les ouvertures 170 comporte des géométries structurées comme des filetages, moletages ou toute autre géométrie faisant intervenir des structurations sur les flancs verticaux du dépôt métallique 40. La couche structurée 17 peut être déposée sur le substrat après structuration, et peut être réalisée dans tout matériau, y compris une résine structurable.

La figure 18 illustre une variante du procédé dans lequel un insert 18 est intégré dans le dépôt métallique 40. L'insert 18 peut être réalisé dans un matériau catalytique métallique ou non, comme par exemple une matière céramique ou autre, en prenant soin de passiver ses flancs verticaux dans le cas d'un matériau catalytique ou conducteur. L'insert 18 permet de rapporter, par exemple, des structures complexes (filetage, etc.) sur les flancs du métal déposé 40 ainsi que sur ses surfaces, les faces de l'insert adjacentes aux faces extérieures du dépôt métallique 40 réalisé pouvant être structurées et/ou l'insert 18 réalisé dans un matériau particulier de manière à permettre des fonctionnalités étendues du composant 41. L'insert 18 peut également servir pour le vissage, chassage, le guidage d'un autre composant, etc., du composant 41 réalisé par le présent procédé.

Le dépôt métallique 40 réalisé dans un moule composé d'une seule couche de résine 20 structurée ou un moule composé de plusieurs niveaux de couches de résine 20 structuré peut être nivelé ou mis à l'épaisseur, par exemple par rodage. La mise à l'épaisseur peut être réalisée pour chaque étape de déposition du métal dans un niveau. La couche de résine 20 structurable peut également être mise à l'épaisseur avant la structuration ou après la structuration.

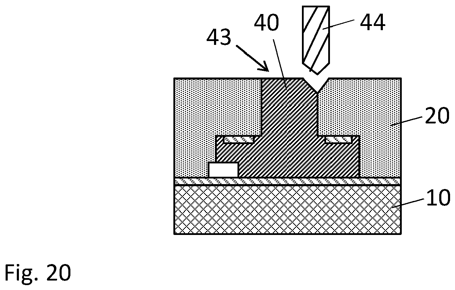

D'autres procédés de surfaçage ou d'usinage après la déposition du dépôt métallique 40 sont possibles notamment, par exemple, la figure 19 illustre un procédé d'usinage (lamage, dans ce cas) sur une première face 42 du dépôt métallique 40, tandis que la figure 20 illustre un procédé d'usinage (par exemple un anglage avec un outil d'anglage 44 sur une deuxième face 43 du dépôt métallique 40, après avoir au préalable retourné la couche de résine 20 métallisée. Pour ce faire, un élément de support 10' est monté solidaire (par exemple avec une couche de maintien et/ou sacrificielle 15', comme illustré, pour faciliter son maintien et/ou sa désolidarisation) du côté du dépôt métallique 40 (deuxième face 42 du dépôt métallique 40) opposé au substrat, le substrat étant ensuite retiré (par délaminage, dissolution, etc.), permettant ainsi de libérer la première face du dépôt métallique 40. Cette variante permet notamment de réaliser des géométries non verticales, difficiles à réaliser dans un moule en résine structurée 20, notamment lorsque la structuration est réalisée par exposition à des rayons sensiblement perpendiculaires à la surface du substrat.

Ainsi, la variante illustrée en figure 16 peut être précédée d'une étape de remplissage de la structuration réalisée dans le substrat 10 d'une couche de résine 20 structurable de manière à obtenir un niveau du moule structuré compris dans l'épaisseur du substrat et pouvant être défini par la structuration du substrat et une étape optionnelle de structuration de cette couche de résine 20.

Sans sortir du cadre de l'invention, les variantes décrites précédemment et illustrées de manière non exhaustive dans les figures 5 à 20 peuvent être combinées entre elles en nombre et séquencement divers, pour permettre de combiner les avantages de chacune de ces variantes.

Le procédé divulgué ici permet de produire économiquement jusqu'à la moyenne série des composants complexes de haute précision.

Les surfaces du substrat 10 et de la résine structurée 20 sur lesquelles le métal est déposé doivent permettre l'amorce de la déposition, c'est-à-dire qu'elles doivent être rendues catalytiques ou susceptibles d'être rendues catalytiques, préférablement nettoyées.

L'obtention d'une première couche d'amorce 12 pour la croissance du premier niveau du dépôt métallique peut être obtenue par tout procédé permettant la formation d'une couche catalytique ou l'activation d'un matériau susceptible d'être rendu catalytique. (?)

Par activation d'un matériau susceptible d'être rendu catalytique, on entend le rendre catalytique en changeant son potentiel de passivation ou, dans le cas d'un matériau conducteur et non catalytique, en le mettant en contact avec un matériau catalytique, ce qui le rend lui aussi catalytique. A titre d'exemple, l'or est catalytique dans un bain comprenant du bore, et conducteur mais non catalytique dans un bain comprenant du phosphore. Dans ce dernier cas, il peut être rendu catalytique en le mettant en contact avec un matériau catalytique, comme par exemple le fer.

Dans le cas de la formation d'une couche catalytique, une variante consiste à déposer un matériau catalytique, comme par exemple le platine ou le palladium. De manière alternative, une couche catalytique peut être obtenue par chimie des sels, qui comprend notamment la réduction chimique de sels métalliques catalytiques, l'emploi de sels métalliques photosensibles, comme par exemple des sels d'argent (procédé argentique), des chlorures d'or, une solution de sels d'oxalate de fer et de sels de platine ou palladium (procédé platinotypie), ou encore l'emploi de sels catalyseurs en surface. Les étapes de dépôt de sels photosensibles peuvent comprendre plusieurs étapes dont l'ordre peut être changé, certaines étapes pouvant même être supprimées.

La déposition de sels photosensibles peut se faire sur toute ou partie des surfaces d'amorce pour les rendre catalytiques. Cette déposition peut se faire sur une surface préalablement fonctionnalisée pour permettre une meilleure adhésion de la couche d'amorce sur le substrat. Cette étape peut donc être réalisée à plusieurs moments du procédé de réalisation du moule structuré. Ainsi, elle peut par exemple se faire avant dépôt de la première couche de résine 20 structurable, après dépôt de la résine 20 structurable, et dans ce cas, avant ou après exposition de la résine, ou encore après obtention du moule par structuration. Il est ainsi possible de générer une première couche d'amorce 12 partielle ou entière sur le premier niveau d'un moule, et ce à plusieurs moments du procédés.

La déposition des sels est généralement réalisée par immersion dans un bain contenant de tels sels, cette technique s'apparentant aux procédés utilisés dans les procédés de photographie, notamment argentique. Ainsi, il peut être fait appel à des solutions contentant des sels d'argent comme un nitrate d'argent, un acétate d'argent, un oxalate d'argent, un halogénure d'argent ou encore un perchlorate d'argent, bien que cette dernière catégorie présente des risques liées à sa manipulation.

Une fois déposés et séchés, les sels sont soumis à une exposition lumineuse totale ou partielle, notamment afin de procéder des dépôts sélectifs, pour les figer sur la surface. Cette opération de révélation, notamment dans le cas du nitrate d'argent, donne de l'argent métallique sur les parties exposées, ce qui rend la surface localement catalytique. Pour les bains electroless où l'argent métal n'est pas catalytique, il est nécessaire de procéder à la substitution d'une partie de l'argent métallique par du platine, du palladium ,de l'or ou d'autre métaux précieux par une réaction d'oxydo-réduction avec des sels de platine, de palladium, d'or ou d'autre métaux précieux et le métal argent.

Une étape optionnelle de révélation des sels insolés dans un révélateur, comme par exemple de l'hydroquinone, permet d'obtenir des agrégats métalliques plus gros, rendant ainsi la surface plus catalytique, ce qui peut être préférable pour favoriser l'amorce de croissance dans un procédé de métallisation chimique. En prolongeant la croissance des agrégats métalliques, la surface peut passer de catalytique uniquement à conductrice, ce qui peut dans ce cas permettre la croissance par un procédé d'électrodéposition.

Dans un mode de réalisation ne faisant pas partie de l'invention, le dépôt métallique 40 peut faire appel à une première étape de dépôt métallique par voie chimique sur un premier niveau, à partir d'une première couche d'amorce 12 catalytique, et une étape postérieure de dépôt métallique par voie électrochimique (électrodéposition) sur un niveau suivant, à partir d'une deuxième couche d'amorce 12' constituée par une surface conductrice et/ou catalytique (par exemple, dans le cas d'une couche d'amorce par sels métalliques, un espacement suffisamment proche des sels catalytiques permet la croissance par nucléation du dépôt métallique).

Dans un mode de réalisation, le substrat 10 et la résine structurée 20 comprennent une surface active 14 rendue ou susceptible d'être rendue catalytique à partir de laquelle le dépôt métallique est réalisé. Le substrat 10 peut être lui-même non catalytique et comprendre, sur sa face 11, une première couche d'amorce 12. Par exemple, le substrat 10 peut comprendre une plaque en silicium à la surface (face 11) de laquelle est réalisée une première couche d'amorce 12 catalytique. Alternativement, le substrat 10 peut comprendre un verre ou une céramique. Dans le cas où la couche d'amorce 12 est une couche conductrice, celle-ci peut être notamment une couche de nickel, de cuivre, de fer, de platine, de palladium, d'acier inoxydable, d'or ou d'un autre métal et/ou une combinaison de ces couches.

Selon une autre forme d'exécution, le substrat 10 peut être réalisé dans un matériau métallique catalytique ou susceptible d'être rendu catalytique et peut comprendre, par exemple, un alliage comprenant au moins un élément métallique choisi parmi l'aluminium, le cuivre, le fer, le platine, le palladium, le nickel, l'or, ou un autre métal ou alliage approprié.

Un substrat 10 métallique a l'avantage d'avoir un coefficient de dilatation thermique proche de celui du métal déposé. Par exemple, un nickel phosphore (NiP) est typiquement déposé à une température entre environ 70°C à 95°C. En refroidissant, un substrat en silicium pourrait légèrement se contraindre. Cet effet sera réduit avec un substrat métallique dont le coefficient de dilation thermique serait proche de celui du matériau déposé.

D'autres substrats 10 en matériau catalytique peuvent inclure un polymère, une céramique ou un verre dopés avec des éléments catalytiques comme des nano- et/ou microparticules métalliques catalytiques. Dans une forme d'exécution particulière, une céramique catalytique comme un nitrure de titane par exemple, peut être utilisée.

Selon une autre forme d'exécution, le substrat 10 peut être réalisé dans un matériau non catalytique et/ou non conducteur comme un polymère, un composite, un verre, une céramique ou un métal non catalytique, la face 11 du substrat 10 recevant le dépôt 40 étant alors rendue catalytique, en partie ou intégralement, par des moyens appropriés. Des métaux à faible pouvoir d'adhésion comme l'or, l'acier inoxydable, certains alliages de chrome ou l'aluminium pourront être favorisés pour faciliter le retrait des composants.

Dans une forme d'exécution, des sels ou chlorures métalliques peuvent être utilisés, comme par exemple des sels d'éléments précieux (comme par exemple l'argent, le platine, le palladium ou encore l'or). Ces sels pourront ou non être photo-réduits et/ou réduits chimiquement.

Dans une forme d'exécution, une seconde couche d'amorce peut être obtenue par le dépôt d'un matériau conducteur. Cette couche peut être formée de différentes manières, comme par exemple par un dépôt en phase vapeur (généralement un PVD) ou un dépôt en phase chimique (généralement un CVD). Afin d'obtenir une couche partiellement recouverte, différents procédés peuvent être employés, comme par exemple l'épargne ou le lift-off, pour ne recouvrir que la partie désirée de la surface, ou encore la gravure après déposition, pour retirer les parties non désirées de la couche.

Selon un mode de réalisation de l'invention, la résine 20 structurable sera choisie parmi le groupe comprenant les résines photosensibles, celles-ci pouvant être de type positives ou négatives. La résine 20 est appliquée sur la face 11 du substrat 10. Selon une forme d'exécution préférée, la résine 20 comprend une résine photosensible négative à base d'époxy. Par exemple, la résine peut comprendre une résine époxy octofonctionnelle de type SU-8 qui polymérise sous l'action d'un rayonnement UV. D'autre résines peuvent réagir à des rayonnements de type rayons-x.

Selon un mode de réalisation, la structuration de la couche de résine 20 consiste à irradier au travers d'un masque 30 (voir la figure 2), la couche de résine 20 préalablement appliquée sur la face 11 du substrat 10. Cette couche de résine 20 est polymérisée selon le motif du masque 30 et les parties de la couche non polymérisées sont éliminées par voie chimique. La partie de résine 20 restante forme un moule comportant une ou plusieurs cavités 21 et définissant le contour 22 du composant 41.

Dans le cas particulier d'une résine photosensible négative comme par exemple le SU8, un recuit de la couche de résine photosensible provoque la polymérisation dans les zones ayant reçu un rayonnement UV. Cette partie polymérisée devient insensible à la plupart des solvants par opposition aux zones non irradiées qui sont dissoutes par un solvant.

Dans un tel cas, la structuration de la couche de résine 20 consiste à développer les zones non insolées de la couche de résine 20 photosensible pour faire apparaître par endroits, c'est-à-dire dans les ouvertures 21, la face 11 du substrat 10 (ces portions exposées de la face 11 correspondent alors à la surface active 14). Dans le cas d'une résine de type SU-8, cette opération peut être réalisée par dissolution des zones non insolées au moyen d'un solvant choisi parmi la GBL (gammabutyrolactone) et le PGMEA (propylène glycol méthyle éthyle acétate). Un moule en résine photosensible insolée présentant les contours 22 de la structure métallique est ainsi réalisé.

La couche de résine 20 peut être déposée sur le substrat 10 avec une épaisseur d'au moins 50 µm, voire d'au moins 100 µm. Selon le type de résine utilisée, il peut être nécessaire de déposer successivement plus d'une couche de résine 20 sur le substrat 10 afin d'atteindre l'épaisseur de la couche de résine souhaitée.

Selon un autre mode de réalisation de l'invention, la résine 20 structurable sera choisie parmi le groupe comprenant des résines durcissables par radiation. Dans ce mode de réalisation, la structuration se fait de manière préférentielle par exposition à une source à faisceau d'électrons. Ce procédé est le plus souvent désigné sous le terme de lithographie à faisceau d'électrons (« e-beam lithography ») et présente un certain nombre d'avantages, notamment une précision accrue, de l'ordre du nanomètre. Alors que la gravure par « e-beam lithography » est le plus souvent réalisée sans masque, de manière sérielle, il est également possible de la combiner à l'utilisation de masques, ce qui rend le procédé plus rapide et pallie aux défauts de vitesse rencontrés dans l'application du procédé sans masque. Une telle possibilité a déjà été présentée dans les documents US3544790 et US3681103.

Un dépôt métallique 40 est ensuite réalisé dans les ouvertures 21 du moule en résine 20 par un procédé de métallisation chimique, cette métallisation chimique pouvant être combinée, dans une étape ultérieure, avec une étape de métallisation galvanique. Le dépôt métallique 40 peut être cru jusqu'à une épaisseur inférieure à celle de la couche de résine 20, sensiblement la même épaisseur, ou encore au-delà de la surface supérieure de la résine 20. La figure 3 montre un dépôt métallique 40 réalisé sensiblement à la même épaisseur que la couche de résine 20.

Le dépôt métallique 40 peut comprendre une couche de nickel (ou d'un de ses alliages) chimique ou une couche obtenue par nickelage chimique.

Le nickelage chimique est un procédé de déposition auto-catalytique qui se produit en présence d'un agent réducteur, tel que l'hydrophosphite de sodium (NaPO₂H₂·H₂O) qui réagit avec les ions métalliques pour déposer le métal. Le nickel peut être déposé avec différents pourcentages de phosphore, par exemple entre 2% et 5% (faible teneur en phosphore), entre 5% et 8% (teneur en phosphore moyenne) ou entre 8% et 15% (haute teneur en phosphore), voire encore entre 15% et 20%. La dureté sans traitement thermique du dépôt de nickel phosphore chimique est typiquement comprise entre 520 HV pour la faible teneur en phosphore et 650 HV pour la haute teneur en phosphore.

D'autres types de bains chimiques permettant des dépôts épais peuvent être utilisés, et plus particulièrement mais sans s'y limiter, des bains contenant au moins un élément d'un groupe comprenant le cobalt, le bore, le phosphore, le nickel, le cuivre et l'or. Ces métaux ou alliages peuvent en outre incorporer l'un ou plusieurs d'éléments comprenant le tungstène, le molybdène, le chrome, l'étain, le fer, pour obtenir des alliages avec des propriétés modifiées.

Ainsi, des sels de ces métaux ajoutés aux bains de base sont coréduits pour améliorer des propriétés comme la dureté, le coefficient de frottement, le magnétisme ou encore les propriétés de dilatation et de thermoélasticité.

Le dépôt métallique 40 peut être réalisé dans les ouvertures 21 avec une épaisseur d'au moins 50 µm et de préférence d'au moins 100 µm. Des épaisseurs du dépôt métallique 40 supérieures à 150 µm, voire 500 µm sont également possibles. L'épaisseur du dépôt métallique 40 peut être déterminée par la vitesse et le temps de déposition.

Un composant 41 de forme complexe à plusieurs niveaux, par exemple une roue dentée avec son pignon ou un plateau avec sa cheville, peut être réalisé en plusieurs étapes, chaque étape pouvant comporter la déposition puis la structuration d'une couche de résine 20 et la croissance d'un dépôt métallique 40 dans la couche de résine 20 structurée. De manière alternative, toutes les étapes de structuration du moule à plusieurs étages peuvent être réalisées avant le remplissage du moule par le dépôt métallique. Les niveaux du composant ainsi fabriqué sont intimement liés entre eux grâce à la précision de la structuration du moule.

Dans une autre forme d'exécution ne faisant pas partie de l'invention, il est possible de réaliser un dépôt multimatériaux faisant appel à un procédé de déposition chimique ; cependant, il apparaît tout aussi évident qu'il devient dès lors possible d'alterner les procédés de déposition chimique et de métallisation électrochimique, pour combiner, si nécessaire, des matériaux issus des deux procédés.

Une fois le dépôt métallique 40 réalisé, il peut être nécessaire de mettre à niveau sa face supérieure par une opération de rodage, de polissage, d'un usinage chimique, ou tout autre moyen équivalent. Selon la solidité du substrat 10, cette opération de mise à niveau peut se faire immédiatement après le dépôt chimique, avant la séparation du dépôt métallique 40 du substrat 10. Si nécessaire, la face inférieure du composant peut aussi être soumise aux mêmes opérations, avant ou après séparation du moule. Pour réaliser cette opération avant séparation du moule, il peut être avantageux de maintenir les pièces de manière rigide sur un élément de support 10' comme illustré en figure 20.

De même, une opération d'usinage mécanique des composants 41 sur leur substrat 10 présente l'avantage de bénéficier d'une précision accrue et d'une répétabilité des géométries obtenues en raison du positionnement extrêmement précis des pièces entre elles d'une part et de la réduction de la chaîne de cotes résultant de ce positionnement.

Dans un autre mode de réalisation de l'invention, il est également possible de procéder à un positionnement de composants, réalisés au préalable, par des géométries du substrat 10 et/ou de la couche de résine 20 structurée, de manière à intégrer ces composants dans la géométrie du composant 41 final lors de la croissance métallique chimique.

Dans un autre mode de réalisation encore, il est aussi possible de structurer le substrat 10 de sorte à ce que la géométrie du composant 41 obtenu comporte les géométries inverses de ces géométries, comme par exemple illustré en figure 16. Ainsi, il est possible de réaliser des structurations de surface, comme des finitions, par exemple des décorations horlogères (Côtes de Genève, perlage, satinage, soleillage, etc.), la gravure d'informations ou encore des géométries comprenant l'anglage, le lamage ou autre.

Sans sortir du cadre de l'invention, il est également possible de combiner plusieurs de ces variantes pour obtenir un composant 41 à géométrie complexe et intégrant une pièce réalisée au préalable par tout procédé de réalisation connu.

Dans un mode de réalisation, le dépôt métallique 40 comprend un métal ou un alliage métallique et des particules céramiques, codéposées avec le métal ou l'alliage métallique par un procédé de métallisation chimique (electroless metal plating).

Selon une variante, le métal peut comprendre le nickel. Ce dernier peut être déposé chimiquement et/ou par électrolyse, avec différents pourcentages de phosphore et avec codéposition de particules. Une telle déposition permet d'obtenir un dépôt métallique composite 40 comprenant une matrice de nickel phosphore et des particules dispersées dans la matrice.

Les particules codéposées peuvent comprendre des particules inorganiques, telles que des particules céramiques. Les particules céramiques peuvent comprendre des particules de carbure, des particules de nitrure, des particules d'oxyde, des particules de fluorure, ou une combinaison de ces particules.

Par exemple, les particules inorganiques peuvent comprendre (seules ou en combinaison) des particules de fluorure de cérium (CeF3), des particules d'alumine (Al2O3), de carbure, tel que le carbure de silicium (SiC), de nitrure, tel que le nitrure de bore hexagonal (h-BN), ou d'autres particules dures. Ces particules permettent d'accroître la résistance à l'abrasion de la couche déposée 40.

Les particules organiques et inorganiques permettent également d'apporter au dépôt métallique 40 des propriétés autolubrifiantes. Un dépôt de nickel (Ni) ou de nickel phosphore (NiP) est très difficile à lubrifier. L'adjonction des particules de céramique au dépôt modifie l'énergie de surface du dépôt métallique 40 et permet d'améliorer les propriétés de lubrification de cette dernière. L'adjonction des particules de céramique permet également un épilamage de la surface du dépôt métallique 40 par fonctionnalisation de la surface.

Les particules peuvent être de forme sphérique ou non. Par exemple, les particules peuvent prendre la forme des fibres céramiques submicronique (par exemple du SiC) de manière à augmenter la résistance à la traction du dépôt métallique 40.

Les particules céramiques peuvent comprendre des fibres submicroniques, par exemple des fibres submicroniques de SiC.

### Exemple

Selon une forme d'exécution, les particules utilisées sont des céramiques car elles permettent une codéposition en épaisseur plus importante que d'autre type de matériaux comme le PTFE.

Dans un exemple, un nickel phosphore (NiP) est déposé chimiquement avec codéposition de particules de nitrure de bore hexagonal (h-BN). Un tel dépôt métallique composite, également connu sous le nom de "Lubrinip BN" (fourni par la société Atela SA), a de bonne propriété lubrifiante de par sa structure cristalline en feuillet et permet un taux important d'incorporation des particules de h-BN (entre 10% et 15%).

Le dépôt métallique composite 40 peut être réalisé à une température comprise entre 70°C et 90°C et une valeur de pH comprise entre 4.5 et 5.0. La composition du bain de déposition peut comprendre du nickel dans une concentration comprise entre 5.5 g/l et 6.0 g/l; entre 25 g/l et 30 g/l d'hypophosphite; et des stabilisants, selon tests éprouvette.

Le bain peut comprendre en outre entre 1 et 5% en volume de particules de nitrure de bore hexagonal (h-BN). Cette concentration est mesurée après décantation à chaud du bain pendant 24h. Le diamètre des particules de h-BN est d'environ 0.5 µm.

La vitesse de déposition peut être comprise entre 8 µm/h et 15 µm/h et le temps de déposition est de 13 heures à 20 heures, selon vitesse de dépôt et l'épaisseur voulue.

Le dépôt métallique composite 40 déposée peut comprendre 85%vol. à 90%vol. de la matrice de NiP et entre 10%vol. et 15%vol des particules de h-BN. La matrice de NiP peut comprendre entre 92% et 96% de nickel et entre 4% et 8% de phosphore.

Les propriétés mécaniques du dépôt métallique composite 40 obtenu a une dureté entre 480 HV et 500 HV avant traitement thermique, et entre 750 HV et 780 HV après traitement thermique.

Le dépôt métallique composite 40 peut être magnétique ou légèrement magnétique (à partir de 12% de phosphore, le dépôt 40 n'est plus magnétique). Le dépôt métallique composite 40 a une densité théorique comprise entre 7.1 et 7.64 et une morphologie cristallographique nanoscopique ou amorphe, avant traitement thermique.

Le dépôt métallique composite 40 peut être cru avec une épaisseur d'au moins 50 µm et de préférence d'au moins 100 µm. Des épaisseurs du dépôt métallique composite 40 supérieures à 150 µm sont également possibles. La codéposition du nickel phosphore avec les particules céramiques permet de déposer le dépôt métallique composite 40 avec des épaisseurs de plus de 450 µm, épaisseurs très difficile à atteindre pour un dépôt chimique sans la présence des particules.

Les particules de h-BN n'étant pas chargées par le surfactant, leur codéposition avec le NiP est passive

La concentration de particules h-BN dans le dépôt métallique composite 40 réalisé dépend cependant de la cinétique de réduction du bain de déposition, et plus particulièrement de la concentration en stabilisant dans le bain.

Ainsi plus la concentration en stabilisant dans le bain est élevée, moins la concentration en particules h-BN est importante dans le dépôt

Une augmentation de la vitesse de déposition, et donc de la croissance du dépôt 40, accroît risque de défaut dans le dépôt, et augmente donc les tensions internes dans le dépôt. Une croissance trop rapide risque de déformer le substrat 10 ainsi que les composants fabriqués sur le substrat. Une augmentation de la concentration en sels usagés dans le bain augmente également les tensions internes dans le dépôt métallique composite 40 déposé.

Afin de minimiser les tensions internes dans le dépôt, un taux de croissance du dépôt de 10 µm à 12 µm / heure peut être avantageusement sélectionné. Ce taux de croissance indicatif pour un dépôt electroless est plus faible que celui typiquement obtenu dans le cas d'une déposition galvanique (environ 20 µm à 50 µm / heure). La couche composite 40 déposée chimiquement aurait donc moins de tensions internes que celle déposée galvaniquement.

Notons que la cinétique de déposition du NiP en présence des particules doit également tenir compte de la tenue de la résine 20 aux conditions acide ou basique du bain, de la croissance du dépôt à l'interface de la résine 20, et du dépôt métallique composite 40 (morphologie du composant). La cinétique peut également dépendre de la croissance du dépôt dans les cavités 21, des dimensions des composants à produire (taille des grains de h-BN, présence de bulles lors de la déposition, croissance du dépôt à l'interface avec la résine 20), du démoulage de la couche déposée 40 de la résine 20, et de la tenue des composants au traitement thermique (possiblement réalisé pour augmenter la dureté du composant).

L'étape de libérer le dépôt métallique 40 de la résine 20 et du substrat 10 peut être réalisée par une dissolution du substrat 10 lorsque celui-ci est soluble, comme c'est le cas d'un substrat en silicium ou aluminium, ainsi que du moule en résine 20. L'étape de libérer le dépôt métallique 40 peut également être réalisée par une dissolution du moule en résine 20 uniquement, lorsque le dépôt métallique 40 est entièrement supporté par le moule 20, comme illustré sur les variantes ③ et ④ de la figure 2a et ④ et ⑤ de la figure 2b. Alternativement, lorsqu'elle est présente, la première couche d'amorce 12 peut faire office de couche sacrificielle 15 qui est dissoute, par exemple une couche 12 en titane, zinc ou aluminium, libérant le dépôt 40 du substrat 10, qui peut être constitué d'une céramique, un verre ou un métal, tel que le nickel, qui résiste à l'agent chimique utilisé pour la dissolution de la couche d'amorce 12. La figure 4 représente le dépôt métallique 40 formant le composant 41, libéré de la résine 20 et du substrat 10.

L'étape de libérer le composant 41 peut également être réalisée par une séparation mécanique (stripping), par exemple par délamination, du dépôt métallique 40 du substrat 10 et un retrait, par exemple par dissolution chimique, de la résine 20. La séparation mécanique est possible lorsque l'accroche entre le dépôt 40 et le substrat 10 est modérée. Cela est par exemple le cas pour un substrat 10 comportant une couche métallique 12 en chrome qui permet une accroche modérée.

### Numéros de référence employés sur les figures

- 10: substrat
- 10': élément de support
- 11: face
- 12: première couche d'amorce
- 12': deuxième couche d'amorce
- 120: portion de surface structurée
- 13: couche isolante
- 14: surface active
- 14': premier niveau de la surface active
- 14": deuxième niveau de la surface active
- 15: couche sacrificielle
- 15': couche sacrificielle / de maintien supplémentaire
- 16: structure du substrat
- 17: couche structurée
- 170: ouverture
- 18: insert
- 20: résine
- 21: ouverture
- 22: contour du composant
- 30: masque
- 31: ouvertures du masque
- 40: dépôt métallique
- 41: composant
- 42: première face du dépôt métallique
- 43: deuxième face du dépôt métallique
- 44: outil d'usinage

## Revendications

1. Procédé pour la fabrication d'un composant horloger, comprenant les étapes de:
se munir d'un substrat (10) dont au moins une (11) des faces est destinée à recevoir une résine structurable (20);
appliquer sur ladite au moins une face (11) une couche de la résine structurable (20);
structurer la résine (20) de manière à former un moule comprenant des ouvertures (21) laissant apparaitre une surface active (14), la surface active (14) comportant au moins un premier niveau (14');
former un dépôt métallique (40) dans les ouvertures (21) du moule en résine (20);
libérer le dépôt métallique (40) du moule (20) et du substrat (10) de sorte à obtenir le composant;
une première couche d'amorce (12) étant formée sur, ou réalisée par, au moins une partie du premier niveau (14') de ladite surface active (14) avant de former le dépôt métallique (40), le dépôt métallique (40) comprenant
un métal ou un alliage métallique et des particules céramiques, codéposées avec le métal ou l'alliage métallique par un procédé de métallisation chimique, exempt d'activation électrique.

2. Le procédé selon la revendication précédente,
dans lequel les étapes d'appliquer la couche de résine structurable (20) et de structurer la résine (20) sont répétées afin d'obtenir un moule à plusieurs niveaux.

3. Le procédé selon l'une des revendications précédentes,
dans lequel une deuxième couche d'amorce (12') est formée sur au moins un deuxième niveau (14") de la surface active (14).

4. Le procédé selon l'une des revendications précédentes, dans lequel la première couche d'amorce (12) et la deuxièmes couche d'amorce (12') peuvent être catalytiques ou susceptibles d'être rendues catalytiques.

5. Le procédé selon l'une des revendications précédentes,
dans lequel le métal ou l'alliage métallique est du nickel phosphore (NiP).

6. Le procédé selon l'une des revendications précédentes,
dans lequel lesdites particules céramiques comprennent des particules de carbure, des particules de nitrure, des particules d'oxyde, des particules de nitrure, des particules de fluorure, ou une combinaison de ces particules.

7. Le procédé selon la revendication précédente,
dans lequel lesdites particules céramiques comprennent des fluorure de cérium (CeF3), des particules de carbure de silicium (SiC), des particules d'alumine (Al2O3) ou une combinaison de ces particules.

8. Le procédé selon la revendication 6,
dans lequel lesdites particules de céramique comprennent des particules de nitrure de bore hexagonal (h-BN).

9. Le procédé selon l'une des revendications précédentes,
dans lequel la composition de la matrice métallique (40) comprend en volume entre 85% et 96% de nickel, entre 4% et 15% de phosphore et entre 10% et 15% de particules de nitrure de bore hexagonal (h-BN).

10. Le procédé selon l'une des revendications précédentes,
dans lequel lesdites particules céramiques comprennent des fibres submicroniques.

11. Le procédé selon la revendication 10,
dans lequel lesdites fibres submicronique comprennent des fibres de SiC.

12. Le procédé selon l'une des revendications précédentes,
dans lequel le dépôt métallique (40) est formé avec une épaisseur d'au moins 50 µm et de préférence d'au moins 100 µm.

13. Le procédé selon l'une des revendications précédentes,
dans lequel la couche métallique (40) a une dureté entre 480 HV et 500 HV non traité thermiquement, et entre 750 HV et 780 HV après traitement thermique.

## Patentansprüche

1. Verfahren zur Herstellung einer Uhrenkomponente, umfassend die folgenden Schritte:
Bereitstellen eines Substrats (10), von dem mindestens eine Fläche (11) dazu bestimmt ist, ein strukturierbares Harz (20) aufzunehmen;
Aufbringen einer Schicht des strukturierbaren Harzes (20) auf die mindestens eine Fläche (11);
Strukturieren des Harzes (20), um eine Form mit Öffnungen (21) bereitzustellen, die eine Wirkfläche (14) freigeben, wobei die Wirkfläche (14) mindestens eine erste Ebene (14') aufweist;
Bilden einer Metallablagerung (40) in den Öffnungen (21) der Harzform (20);
Lösen der Metallablagerung (40) von der Form (20) und dem Substrat (10), um die Uhrenkomponente zu erhalten;
eine erste Grundierungsschicht (12) auf mindestens einem Teil der ersten Ebene (14') der Wirkfläche (14) gebildet wird oder durch diese gebildet wird, bevor die Metallablagerung (40) gebildet wird, wobei die Metallablagerung (40) ein Metall oder eine Metalllegierung und Keramikpartikel umfasst, die mit dem Metall oder der Metalllegierung durch einen chemischen Metallisierungsprozess, die keine elektrische Aktivierung erfordert, gemeinsam abgelagert werden.

2. Das Verfahren nach dem vorhergehenden Anspruch,
wobei die Schritte des Aufbringens der strukturierbaren Harzschicht (20) und des Strukturierens des Harzes (20) wiederholt werden, um eine mehrschichtige Form zu erhalten.

3. Das Verfahren nach einem der vorhergehenden Ansprüche, wobei eine zweite Grundierungsschicht (12') auf mindestens einer zweiten Höhe (14") der Wirkfläche (14) ausgebildet ist.

4. Das Verfahren nach einem der vorhergehenden Ansprüche, wobei die erste Grundierungsschicht (12) und die zweite Grundierungsschicht (12') katalytisch sein können oder katalytisch gemacht werden können.

5. Das Verfahren nach einem der vorhergehenden Ansprüche, wobei das Metall oder die Metalllegierung Nickelphosphor (NiP) ist.

6. Verfahren nach einem der vorhergehenden Ansprüche, wobei die Keramikteilchen Carbidteilchen, Nitridteilchen, Oxidteilchen, Nitridteilchen, Fluoridteilchen oder eine Kombination dieser Teilchen umfassen.

7. Das Verfahren nach dem vorhergehenden Anspruch,
wobei die Keramikpartikel Cerfluorid (CeF3), Siliziumkarbidpartikel (SiC), Aluminiumoxidpartikel (Al2O3) oder eine Kombination dieser Partikel umfassen.

8. Das Verfahren nach Anspruch 6,
wobei die Keramikpartikel hexagonale Bornitridpartikel (h-BN) umfassen.

9. Das Verfahren nach einem der vorhergehenden Ansprüche, wobei die Zusammensetzung der Metallmatrix (40) volumenmäßig zwischen 85% und 96% Nickel, zwischen 4% und 15% Phosphor und zwischen 10% und 15% hexagonale Bornitrid (h-BN)-Teilchen umfasst.

10. Das Verfahren nach einem der vorhergehenden Ansprüche, wobei die Keramikpartikel Submikronfasern umfassen.

11. Das Verfahren nach Anspruch 10,
wobei die Submikronfasern SiC-Fasern umfassen.

12. Das Verfahren nach einem der vorhergehenden Ansprüche, wobei die Metallablagerung (40) mit einer Dicke von mindestens 50 µm und vorzugsweise mindestens 100 µm gebildet wird.

13. Verfahren nach einem der vorhergehenden Ansprüche, wobei die Metallablagerung (40) eine Härte zwischen 480 HV und 500 HV ohne Wärmebehandlung und zwischen 750 HV und 780 HV nach Wärmebehandlung aufweist.

## Claims

1. A method of manufacturing a watch component, comprising the steps of:
providing a substrate (10) with at least one surface (11) for receiving a structurable resin (20);
applying to said at least one surface (11) a layer of the structurable resin (20);
structuring the resin (20) so as to form a mould comprising openings (21) revealing an active surface (14), the active surface (14) comprising at least a first level (14') forming a metal coating (40) in the openings (21) of the resin mould (20);
releasing the metal coating (40) from the mould (20) and the substrate (10) so as to obtain the watch component;
a first primer layer (12) being formed on, or made by, at least part of the first level (14') of said active surface (14) prior to forming the metal deposit (40), the metal coating (40) comprising a metal or metal alloy and ceramic particles, co-deposited with the metal or metal alloy by an electrically non-activated electroless plating process.

2. The method according to the preceding claim,
wherein the steps of applying the structurable resin layer (20) and structuring the resin (20) are repeated to obtain a multi-level mould.

3. The method according to any of the preceding claims, wherein a second primer layer (12') is formed on at least a second level (14") of the active surface (14).

4. The method according to any of the preceding claims, wherein the first primer layer (12) and the second primer layer (12') may be catalytic or capable of being made catalytic.

5. The method according to any of the preceding claims,
wherein the metal or metal alloy is nickel phosphorus (NiP).

6. The method according to any of the preceding claims,
wherein said ceramic particles comprise carbide particles, nitride particles, oxide particles, nitride particles, fluoride particles, or a combination thereof.

7. The method according to the preceding claim,
wherein said ceramic particles comprise cerium fluoride (CeF3), silicon carbide (SiC) particles, alumina (Al2O3) particles or a combination thereof.

8. The method according to claim 6,
wherein said ceramic particles comprise hexagonal boron nitride (h-BN) particles.

9. The method according to any of the preceding claims, wherein the composition of the metal matrix (40) comprises by volume between 85% and 96% nickel, between 4% and 15% phosphorus and between 10% and 15% hexagonal boron nitride (h-BN) particles.

10. The method according to any of the preceding claims, wherein said ceramic particles comprise submicron fibres.

11. The method according to claim 10,
wherein said submicron fibres comprise SiC fibres.

12. The method according to any of the preceding claims,
wherein the metal coating (40) is formed with a thickness of at least 50 µm and preferably at least 100 µm.

13. The method according to any of the preceding claims, wherein the metal coating (40) has a hardness between 480 HV and 500 HV without heat treatment, and between 750 HV and 780 HV after heat treatment.
